# EUROPÄISCHE PATENTSCHRIFT

(11) **EP 0 696 071 B1**
(45) Veröffentlichungstag und Bekanntmachung des Hinweises auf die Patenterteilung: **02.11.2000**
(21) Anmeldenummer: 95202085.7
(22) Anmeldetag: 31.07.1995
(51) Int. Cl.: H01L 41/09, B41J 2/045, B41J 2/16

(54) **Piezokeramisches Bauteil mit Kammerstruktur, Verfahren zu seiner Herstellung und Vorrichtung mit diesem Bauteil**
Piezoelectric element with chamber structure, method of producing the same and device using this element
Elément piézoélectrique à structure à chambres, procédé de fabrication et dispositif comportant cet élément

(30) Priorität: 04.08.1994 DE 4427564
(43) Veröffentlichungstag der Anmeldung: 07.02.1996
(73) Patentinhaber: Philips Corporate Intellectual Property GmbH, 52064 Aachen (DE); Koninklijke Philips Electronics N.V., 5621 BA Eindhoven (NL)
(72) Erfinder: Dibbern, Uwe, Dr., c/o Philips, D-22335 Hamburg (DE)
(74) Vertreter: Zöllner, Christine

(56) Entgegenhaltungen:
- EP-A- 0 485 241
- EP-A- 0 533 355
- EP-A- 0 600 748
- EP-A- 0 609 080

## Beschreibung

Die Erfindung betrifft ein piezokeramisches Bauteil mit Kammerstruktur mit mindestens zwei in Gruppen im wesentlichen parallel angeordneten Kammern, wobei innerhalb einer Gruppe alle Kammern eine gemeinsame Kammerbasis und je zwei benachbarte Kammern eine gemeinsame Kammerwand aufweisen und die Innenflächen der Kammerbasis und gegebenenfalls der Kammerwände ganz oder teilweise mit Arbeitselektroden belegt sind, und sowohl die Kammerwände als auch die Kammerbasis aus piezoelektrisch polarisiertem Material und gegebenenfalls Hilfselektroden bestehen. Die Erfindung betrifft weiterhin ein Verfahren zur seiner Herstellung und eine Vorrichtung zur gepulsten Emission von Tropfen, insbesondere einen Druckkopf für einen Tintenstrahldrucker, mit einem solchen Bauteil.

Druckköpfe für Tintenstrahldrucker werden im allgemeinen aus piezokeramischen Laminaten gefertigt, die für einen Longitudinal-, Transversal- oder Biegemodus polarisiert sind. Seltener werden Druckköpfe im Schermodus betrieben. Das Betreiben eines Druckkopfes im Schermodus hat jedoch den Vorteil, daß man geringere Arbeitsspannungen benötigt.

Ein kogesintertes Laminat für einen Druckkopf für einen Tintenstrahldrucker, das im Schermodus arbeitet, ist aus der PCT-Anmeldung WO 92/09436 bekannt. Das Laminat umfaßt zwei innere Schichten aus einem piezoelektrischen Material, welche in Dickenrichtung in entgegengesetzter Richtung gepolt sind, weiterhin zwei äußere Schichten aus einem inaktivem Material und eine fünfte Schicht, die zwischen den inneren Schichten abgeschieden wird. Diese fünfte Schicht ist unter den Operationsbedingungen des Druckkopfes elektrisch isolierend und unter den Polarisations bedingungen für die inneren Schichten elektrisch leitend. Sie besteht vorzugsweise aus einem NTC-Material mit einer kritischen Temperatur zwischen der Betriebstemperatur des Druckers und der Polarisationstemperatur. Nachdem die inneren Schichten polarisiert worden sind, kann der Druckkopf von einer Seite her gefertigt werden. Dabei wird die oberste inaktive Schicht wieder entfernt.

Diese Anordnung hat den Nachteil, daß durch das gemeinsame Sintern des Verbundes von drei verschiedenen keramischen Materialien in fünf Schichten aufgrund deren unterschiedlichen thermischen Ausdehnungskoeffizienten sowie unterschiedliche Schrumpfung beim Sintern und durch die piezoelektrische Deformationen mechanische Spannungen entstehen. Ein Teil der Spannungen wird durch die symmetrische Anordnung der inaktiven Schichten zunächst kompensiert. Diese Spannungen werden jedoch frei, wenn die obere inaktive Schicht entfernt wird.

Weiterhin ist aus der EP-A-0 309 147 eine Vorrichtung zur gepulsten Tropfenemission mit einer hochdichten Vielkanalanordnung bekannt, die eine Platte aus einem piezoelektrischem Material sowie ein erstes Substrat umfaßt, mit dem die Platte verbunden ist, wobei diese Platte mit einer Vielzahl von parallelen, oben offenen Kanälen hergestellt wird, die in einer Flächennormalen senkrecht zu der Längsrichtung besagter Kanäle ausgerichtet sind und durch gegenüberliegende Seitenflächen und eine Bodenfläche, die sich zwischen den Seitenflächen erstreckt, definiert ist, weiterhin ein zweites Substrat, das dem ersten Substrat gegenüberliegt und mit den Seitenwänden verbunden ist, so daß die oben offenen Kanäle verschlossen sind, wobei die Seitenwände jeweils ein monolithisches Teil aus einem piezoelektrischem Material umfassen, das zwei entgegengesetzt polarisierte Schichten aufweist, die jeweils dem ersten bzw. dem zweiten Substrat benachbart sind, weiterhin Düsen die mit den Kanälen verbunden sind für den Ausstoß von Tropfen, weiterhin Mittel zum Verbinden der Kanäle mit einem Vorratsbehälter für die Flüssigkeit und Elektroden an gegenüberliegenden Seiten von wenigstens einigen der Seitenwände zur Bildung von Aktuatoren, die im Schermodus arbeiten, um einen Tropfenausschuß aus den Kanälen zu bewirken.

Die Kanalseitenwände nach der EP-A-0 309 147 umfassen jede einen monolithischen Abschnitt eines piezoelektrisch bimorphen Materials, das zwei entgegengesetzt gepolte Schic hten hat und hergestellt wird, indem eine homogene Platte aus einem piezoelektrischem Material zunächst gleichmäßig in Dickenrichtung in einer ersten Polarisationsrichtung polarisiert wird, dann ein linearer Temperaturgradient in Dickenrichtung erzeugt wird und gleichzeitig eine Polarisationsspannung über die Dicke dieser Platte angelegt wird, die in Richtung und Größe so gewählt wird, daß die Mittelschicht der Platte depolarisiert wird, die wärmeren Schichten der Platte in umgekehrter Richtung polarisiert werden und die kälteren Schichten unverändert in der ersten Richtung polarisiert bleiben, wodurch ein monolithisches piezoelektrisches Bimorph entsteht.

Auch diese Anordnung hat den Nachteil, daß ein Verbund zwischen den piezoelektrisch aktiven Seitenwänden der Kanäle und dem passiven Substrat für die Kammerbasis hergestellt werden muß, der aufgrund der piezoelektrischen Deformation der Seitenwände starken mechanischen Spannungen an der Grenzfläche zum Substrat ausgesetzt ist.

Weiterhin ist aus EP-A-0485 241, EP-A-0 609 080, EP-A-0533 355 und EP-A-0 600 748 ein piezokeramisches Bauteil und Herstellungsverfahren bekannt, wobei die Kammerwände und die Kammerbasis der Kammern aus piezoelektrischem Material bestehen, Die Kammerwände sind für einen Schermodus polarisiert.Hierbei treten mechanische Spannungen zwischen den Kammerwänden und der Kammerbasis auf.

Es ist daher die Aufgabe der vorliegenden Erfindung, ein piezokeramisches Bauteil mit Kammerstruktur, das für eine Vorrichtung zur Emission von Flüssigkeitstropfen geeignet ist, zur Verfügung zu stellen, das einen einfacheren Aufbau hat, einfach zu fertigen ist und zudem verbesserte Eigenschaften aufweist.

Diese Aufgabe wird erfindungsgemäß gelöst durch ein piezoelektrisches Bauteil der oben genannten Art, das dadurch gekennzeichnet ist, daß mindestens die Kammerbasis und das untere Teilstück der Kammerwände antiparallel polarisiert sind. Durch diese Anordnung werden die mechanischen Belastungen in dem Bauteil außergewöhnlich niedrig gehalten.

Es kann bevorzugt sein, daß das piezoelektrisch polarisierte Material für einen Schermodus polarisiert ist.

Es kann auch bevorzugt sein, daß das piezoelektrisch polarisierte Material für einen multiplen Schermodus polarisiert ist.

Es kann weiterhin auch bevorzugt sein, daß das obere Teilstück der Kammerwände parallel zur Kammerbasis polarisiert ist.

Es ist auch bevorzugt, daß das für einen multiplen Modus polarisierte Material für die Kammerbasis und die Kammerwände aus Schichten mit unterschiedlicher Materialzusammensetzung bestehen.

In einer anderen Ausführungsform der Erfindung betrifft sie ein piezokeramisches Bauteil mit Kammerstruktur mit mindestens zwei in Gruppen im wesentlichen parallel angeordneten Kammern (ch), wobei innerhalb einer Gruppe alle Kammern eine gemeinsame Kammerbasis (2) und je zwei benachbarte Kammern eine gemeinsame Kammerwand aufweisen und die Innenflächen der Kammerbasis und gegebenenfalls der Kammerwände ganz oder teilweise mit Arbeitselektroden (Eₙ,Eₙ₋₁) belegt sind, und sowohl die Kammerwände als auch die Kammerbasis aus piezoelektrisch polarisiertem Material und gegebenenfalls Hilfselektroden (Eₕ) bestehen, und das piezoelektrisch polarisierte Material bimorph polarisiert ist, so daß in einer jeweils zwei Kammern gemeinsamen Kammerwand das der ersten Kammer benachbarten erste Wandteilstück einschließlich des mit ihm verbundenen Teilstück der Kammerbasis antiparallel zu dem der zweiten Kammer benachbarten Wandteilstücks einschließlich des mit ihm verbundenen Teilstücks der Kammerbasis und antiparallel zum zweiten Wandteilstück der ersten Kammer einschließlich des mit ihm verbundenen Teilstücks der Kammerbasis polarisiert ist.

Die Erfindung betrifft auch ein Verfahren zur Herstellung eines piezokeramischen Bauteils mit Kammerstruktur, bei dem an eine vorpolarisierte Platte aus einem Schichtverbund aus einer Basisschicht, einer inneren Hilfselektrode und einer Deckschicht zwei äußere Hilfselektroden angebracht werden, Polarisationsspannungen zwischen den äußeren Hilfselektroden und der inneren Hilfselektrode angebracht werden, so daß die Basisschicht und die Deckschicht antiparallel polarisiert sind, mindestens die obere Hilfselektrode entfernt wird und eine oder mehrere Kammern so angebracht werden, daß sie sich von der Deckschicht durch die Hilfselektrode und durch den oberen Teil der Basisschicht erstrecken, so daß der untere Teil der Basisschicht als Kammerbasis erhalten bleibt, die Innenflächen der Kammer oder Kammern mit Arbeitselektroden belegt werden, eine Polarisationsspannung zwischen der Basiselektrode und den Arbeitselektroden angelegt wird, so daß der untere Teil der Basisschicht antiparallel zum oberen Teil der Basisschicht und parallel zur Deckschicht polarisiert wird.

Die Erfindung betrifft auch eine Vorrichtung zur gepulsten Emission von Flüssigkeitstropfen, insbesondere für einen Druckkopf für einen Tintenstrahldrucker, ein Telefaxgerät oder ähnliche Geräte, mit einem piezokeramischen Bauteil nach der Erfindung. Es eignet sich auch für Vorrichtungen zum Ausbringen von Klebstofftropfen für das Verkleben von Textilien, technischen Geweben, keramischen Folien und ähnlichem.

Im folgenden wird die Erfindung anhand von Zeichnungen erläutert und es werden Ausführungsbeispiele näher beschrieben.

**Fig. 1** zeigt einen Querschnitt durch ein erfindungsgemäßes Bauteil mit Kammerstruktur, das für einen multiplen Schermodus polarisiert ist.

**Fig. 2** zeigt den Schichtverbundwerkstoff mit fünf Schichten nach dem Stand der Technik zur Verwendung für Tintenstrahldruckköpfe.

**Fig. 3** zeigt den einfach aufgebauten Schichtverbundwerkstoff mit drei Schichten für ein Bauteil nach **Fig.1**.

**Fig.4** zeigt das Bauteil nach **Fig.1** vor der zweiten Polarisation.

**Fig. 5** zeigt die Scherbewegung der Kammern des Bauteiles nach **Fig.1**.

**Fig. 6** zeigt die Scherbewegung der Kammern in einem Bauteil, das für den einfachen Schermodus polarisiert ist.

**Fig. 7** zeigt ein Bauteil, das für den bimorphen Biegemodus polarisiert ist.

**Fig. 8** zeigt ein Bauteil, das monolithisch und für den bimorphen Biegemodus polarisiert ist.

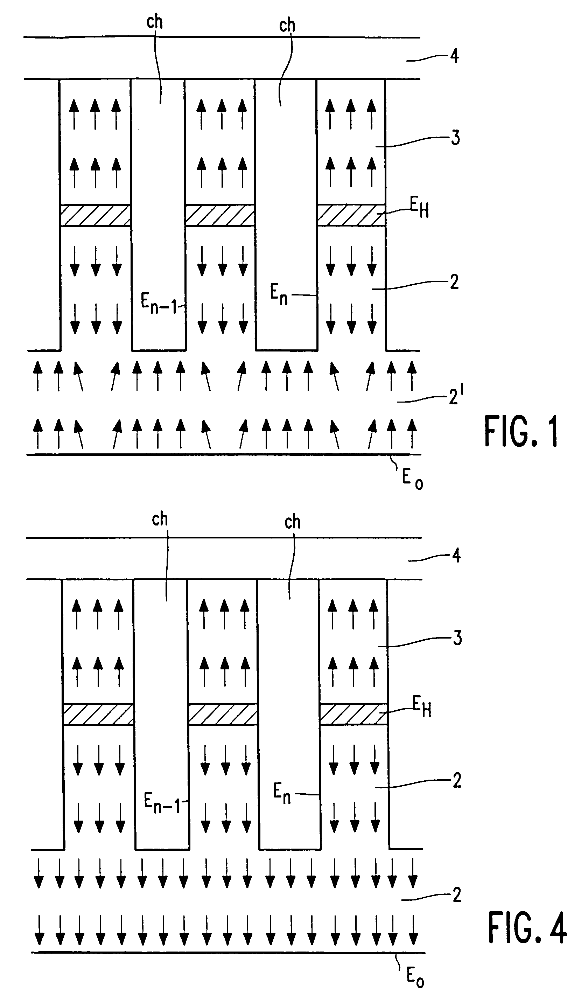

**Fig. 9** zeigt einen Druckkopf mit einem piezokeramischen Bauteilnach der Erfindung.
Eine erste Ausführungsform des erfindungsgemäßen piezoelektrischen Bauteils mit Kammerstruktur ist in **Fig.1** schematisch abgebildet. Das Bauteil arbeitet im multiplen, genauer im dreifachen Schermodus ("Chevrontyp"). Es besteht aus einer piezokeramische Basisschicht mit einem unteren Teil **(2')** und einem oberen Teil **(2)**, einer darüberliegenden, im wesentlichen flächig ausgebildeten Hilf selektrode **E**_{**H**} und einer Deckschicht **(3)**. Bedingt durch den Fertigungsprozeß ist die Unterfläche der Basisschicht mit einer weiteren Hilfselektrode **E**_{**0**} bedeckt. Diese ist jedoch für die Funktion des Bauteils in einer Vorrichtung zur gepulsten Emission von Flüssigkeitstropfen nicht notwendig und kann nachträglich entfernt werden, wenn sie stört. Das Bauteil enthält eine Gruppe von Kammern **(ch)**, die sich durch die durch die Deckschicht **(3)**, die Schicht mit der Hilfselektrode **(E**_{**H**}**)** und durch den oberen Teil der Basisschicht **(2)** erstrecken. Die Innenwände der Kammern sind mit den Arbeits- oder Signalelektroden **E**_{**n-1**}**, E**_{**n**}**,....** ausgekleidet. Für den Druckaufbau werden die Kammern mit einem Deckel **(4)** verschlossen.

Zur Herstellung des erfindungsgemäßen Bauteils mit Kammerstruktur nach **Fig. 1** geht man von einer gesinterten piezokeramischen Platte aus, die einen Schichtverbund aus einer piezokeramischen Deckschicht **(3)**, einer im wesentlichen flächig ausgebildeter Hilfselektrodenschicht **(E**_{**H**}**)** und piezokeramischer Basisschicht**(2)** enthält. Andere Ausführungsformen können auch noch Kohlenstoffschichten in diesem Schichtverbund enthalten.
Als piezokeramisches Material werden keramische Zusammensetzungen, die Perowskite wie Bariumtitanat, Bleizirkontitanat oder Bleimetaniobat mit speziellen Dotierungen enthalten, verwendet. "Weiche" Piezoelektrika, d.h. Piezoelektrika, die eine hohe Ladungskonstante, Kopplungsfaktoren und Permittivitäten, allerdings auch hohe Verluste, aufweisen, sind besonders geeignet. Bei weichen piezoelektrischen Werkstoffen bestehen die Dotierungen aus einigen Mol-% Lanthan, Neodym o.ä. auf den A-Plätzen des Perowskitgitters bzw. Niob auf den B-Plätzen des Perowskitgitters. Im Rahmen der vorliegenden Erfindung kann aber auch jeder andere Werkstoff, der nach Anlegen einer Polarisierungsspannung piezoelektrische Eigenschaften zeigt, verwendet werden.

Das Material für die Hilfselektrode **E**_{**H**} muß einerseits für seine Funktion im Polarisationsprozeß eine gewisse elektrische Leitfähigkeit bei der Polarisationstemperatur zeigen, andererseits würde eine zu gute Leitfähigkeit der Hilfselektrodenschicht bei Normaltemperatur die Funktion des fertigen Bauteils durch Kurzschlußbildung stören. Man verwendet daher vorteilhaft für diese Hilfselektroden-Zwischenschicht ein NTC-Material, z.B. Oxidkeramik auf der Basis von dotiertem Fe₃O₄, Zn₂TiO₄, MgCr₂O₄, dotiertem Nickel-, Mangan-, Cobalt- oder Zinnoxid. Man kann für diese Zwischenschicht auch einen Verbund eines NTC-Materials mit einem piezoelektrischem Material oder ein verwendetes PZT-Material mit anderer Dotierung verwenden. Welchen spezifischen Widerstand das Material bei der Arbeitstemperatur aufweisen muß, läßt sich aus der Schichtdicke der drei Schichten, der relativen Dielektrizitätskonstante der piezoelektrischen Schichten und der Pulsdauer der Arbeitsspannung errechnen. Aufgrund dieser Spezifikation kann das Material dann aus handelsüblichem NTC-Material ausgewählt werden.

Zur Herstellung der Kohlenstoffschichten wird ein Pulver einer leicht oxidierbaren Kohlenstoffmodifikation, z.B. amorpher Kohlenstoff oder Ruß eingesetzt.

Die keramischen Ausgangspulver für das piezoelektrische Material - die nach den bekannten Methoden hergestellt werden -werden zusammen mit einer organischen Bindemittelzusammensetzung in einer Flüssigkeit dispergiert. Aus dem so hergestellten Schlicker mit definierter Viskosität wird eine grünen Folie gegossen, die nach dem Trocknen eine Dicke von 30 bis 50 µm und einen keramischen Anteil von ca. 50 % hat. Die Folie wird dann zu Karten geschnitten.

Nach dem gleichen Verfahren werden Folienkarten für die Hilfselektrodenschichten und die Kohlenstoffschichten hergestellt. Hilfselektroden- und Kohlenstoffmaterial können aber auch zu einer Siebdruckpaste gemischt werden und im Siebdruckverfahren auf die Folien aus piezokeramischen Material aufgetragen werden.

Die piezokeramische Platte wird üblicherweise aus mehreren grünen Einzelfolien zusammengesetzt. Ein typischer Stapelaufbau kann beispielsweise aus einem Stapel von 45 piezokeramikhaltigen Folien für die Basisschicht, einer NTC-Material enthaltenden Folie für die Hilfselektrode und 15 piezokeramikhaltigen Folien für die Deckschicht bestehen. Die Schicht für die innere Hilfselektroden kann auch im Siebdruckverfahren aufgebracht werden.

Dieser Stapel aus grünen Folien wird getrocknet, konditioniert und zu einem Verbund laminiert. Dann wird das Bindemittel ausgebrannt, anschließend wird gesintert.

Auf das gesinterte Folienpaket werden die zwei äußeren Hilfselektroden **E**_{**0**} und **E**_{**c**} aufgebracht, vorzugsweise im Siebdruckverfahren. Dann wird das Paket zu einzelnen Platten mit Abmessungen von beispielsweise 0,5 x 1,0 cm vereinzelt, z.B durch Sägen oder Laserschneiden..

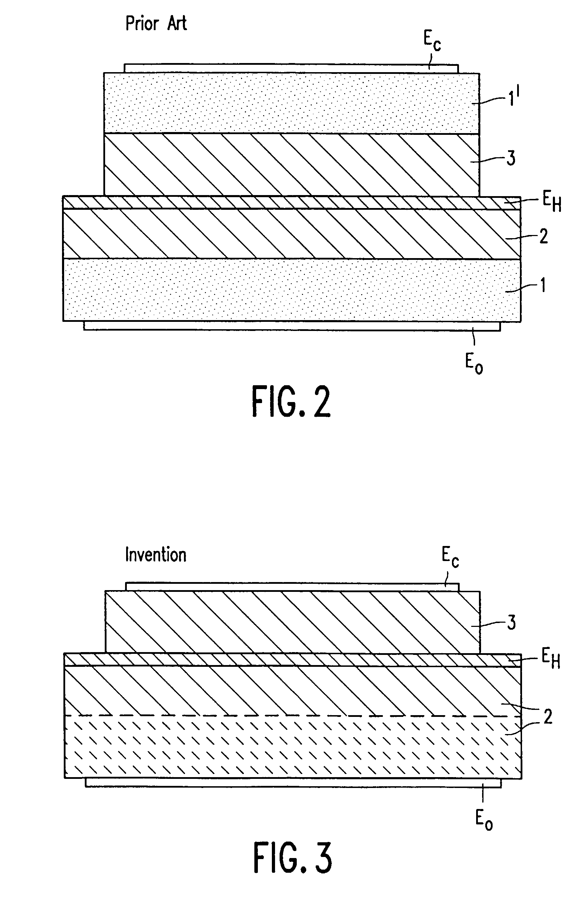

Diese Platte, siehe **Fig. 3**, bildet die Basis für die weiteren Herstellungsschritte.

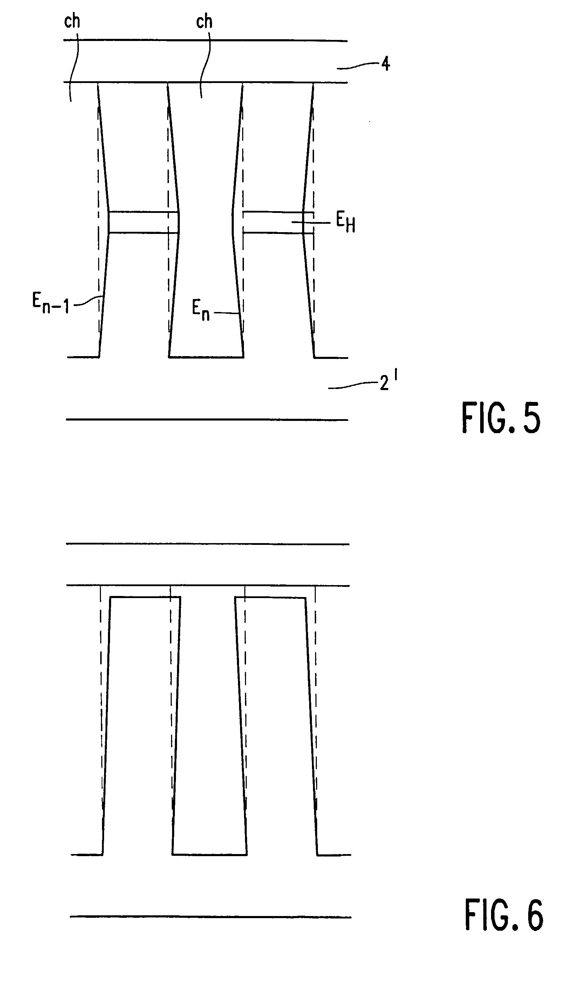

Es werden Polarisationsspannungen angelegt zwischen **E**_{**0**} und **E**_{**H**} bzw. **E**_{**c**} und **E**_{**H**} von ca. 3V/µm und die Basisschicht und die Deckschicht werden bei ca. 150°C in gegensätzlicher Richtung polarisiert. Dies ist in **Fig. 4** durch die Richtung der Pfeile angedeutet. Dann wird die Elektrode **E**_{**c**} entfernt und es werden die Kammern eingearbeitet, beispielsweise durch Schneiden, Bohren oder Fräsen. Der dabei verbleibende untere Teil der Basisschicht **(2')** soll dünn im Verhältnis zur Wandhöhe der Kammern sein. Falls dann die mechanische Festigkeit der Basisschicht nicht ausreichend ist, ist es auch möglich, die Basisschicht etwas dicker auszubilden, wenn gleichzeitig die Hilfselektrode **E**_{**0**} in das Innere dieser Schicht verlegt wird, um die Spannung beim Polen und Umpolen nicht zu groß werden zu lassen. Dazu wird der obige Stapelaufbau abgewandelt, insofern als die Hilfselektrode **E**_{**0**} als siebgedruckte Schicht oder als Stapelfolie an passender Stelle in den Stapelaufbau des unteren Teils der Basisschicht einzufügt wird. Wenn die untere Hilfselektrode als siebgedruckte Schicht in den Stapelaufbau eingefügt werden soll, verwendet man hierfür eine Metallisierungspaste, die keramische Binder enthält, beispielsweise eine Silberpalladiumlegierung mit keramischem Anteil.

Die Innenwände der Kammern werden daraufhin mit den Arbeitselektroden **E**_{**n-1**}**, E**_{**n**} ... belegt. Dies kann beispielsweise durch Aufdampfen im Vakuum, Kathodenzerstäubung oder stromloses Beschichten geschehen. Überflüssige Metallabscheidung auf der Oberfläche der Deckschicht muß entweder schon beim Beschichtungsvorgang durch entsprechendes Abdecken verhindert oder anschließend durch Läppen oder ähnliche Verfahren entfernt werden. Diese Fertigungsstufe ist in **Fig. 4** abgebildet.

Anschließend wird eine Polarisationsspannung zwischen der Hilfselektrode **E**_{**0**} und den Arbeits- oder Signalelektroden **E**_{**n-1**}, **E**_{**n**} ... angelegt, die parallel zu der Polarisation der Deckschicht und entgegengesetzt zur Polarisation des oberen Teils der Basisschicht verläuft.

Dieser Polarisationsvorgang wird bei Raumtemperatur vorgenommen.

Für die Verwendung des erfindungsgemäßen Bauteils für eine Vorrichtung zur gepulsten Emission von Flüssigkeitstropfen ist die Basiselektrode nicht erforderlich. Sie kann daher nach der Fertigstellung des Bauteils entfernt werden, z.B. durch Ätzen oder Schleifen. Da sie die Funktion der Vorrichtung nicht stört, kann sie aber auch erhalten bleiben, insbesondere dann, wenn sie in die Basisschicht integriert wurde.

In einer typischen Ausführungsform hat das piezokeramische Bauteil die Abmessungen 10 x 5 x 1,0 mm. Die Kammern haben eine Breite von 80µm und eine Höhe von 500µm, die Düsen einen Durchmesser von 40µ. Die Anzahl der Kammern in einer Gruppe kann z.B. 24, 48 oder 64 betragen. Zur Bildung von größeren Bauteilen können einzelne Platten mit Kammergruppen horizontal oder vertikal zusammengesetzt werden. Das oben beschriebene Bauteil arbeitet im Schermodus vom Chevron-Typ (Zig-Zag-Typ).Eine Ausführung eines piezokeramischen Bauteils nach dem Stand der Technik, das im einfachen Schermodus arbeitet,,ist wie in **Fig.6** gezeigt.

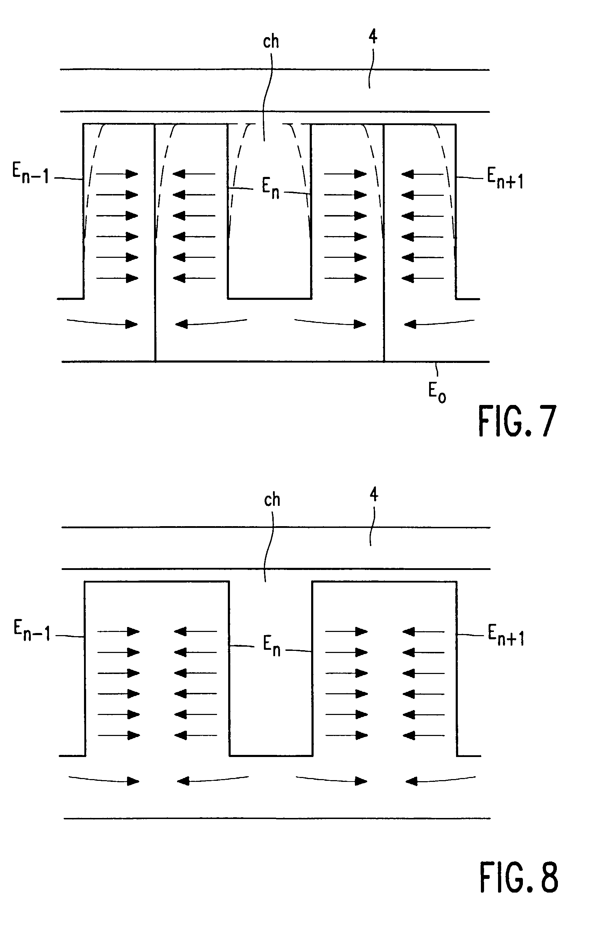

Die Erfindung ist nicht auf die Ausführungsformen, die im Schermodus arbeiten, beschränkt. In einer weiteren Ausführungsform ist das Bauteil für den bimorphen Biegemodus polarisiert. **Fig.7** macht den Aufbau dieses Bauteil deutlich. Hierfür wird zunächst ein Folienstapelverbund hergestellt, der für jede Kammerwand eine Hilfselektrodenschicht **H** enthält. Der bimorphe Biegemodus kann auf zwei Arten realisiert werden. Entweder werden bereits bei der Fertigung die beiden Hälften der Kammerwände zu beiden Seiten der jeweiligen Hilfselektrode gegensinnig polarisiert (Serien-Bimorph-Platte) oder beide Seiten werden zunächst gleichsinnig polarisiert (Parallel-Bimorph-Platte) und der bimorphe Modus wird durch die entgegengesetzte Steuerspannung im Betrieb erzeugt.
In dieser Ausführungsform verlaufen die Kammern nicht senkrecht zu den Schichten des Ausgangslaminates sondern parallel dazu. Deswegen ist es bei der Fertigung dieser Ausführungsform auf einfache Art und Weise möglich, das Kammermuster durch eine siebgedruckte Kohlenstoffschicht vorzubilden. Der Kohlenstoff brennt beim anschließenden Sintern in oxidierender Atmosphäre aus und die Kammerinnenflächen müssen nachfolgend nur noch nachbearbeitet werden.

Eine andere Ausführungsform, die im bimorphen Biegemodus arbeitet, ist die in **Fig. 8** gezeigte Ausführung mit monolithischem Aufbau. Die Polarisation von Kammerwänden und Kammerbasis dieses Bauteils kann nach dem in der EP 0 309 147 angegebenen Verfahren zwischen jeweils zwei benachbarten Arbeitselektroden unter Ausnutzung eines Temperaturgefälles erfolgen.

In einer weiteren, nicht abgebildeten Ausführungsform wird die Auslenkung der Kammerwände und Kammerbasis in einem Bauteil, das für den monomorphem Biegemodus polaisiert ist, dadurch verstärkt, daß die an die Arbeitselektroden angelegte Steuerspannung ein asymmetrisches Feld erzeugt. Dies ist möglich, wenn das piezokeramische Material ein Halbleiter mit einem spezifischen Widerstand von etwa 10⁵ Ωm ist und zusammen mit den Elektroden einen Schottky-Kontakt bildet. Eine Reihe von möglichen Materialien ist in K.Uchino et al., Japanese Journal of Applied Physics 26(7) 1046-1049 (1987) angegben.

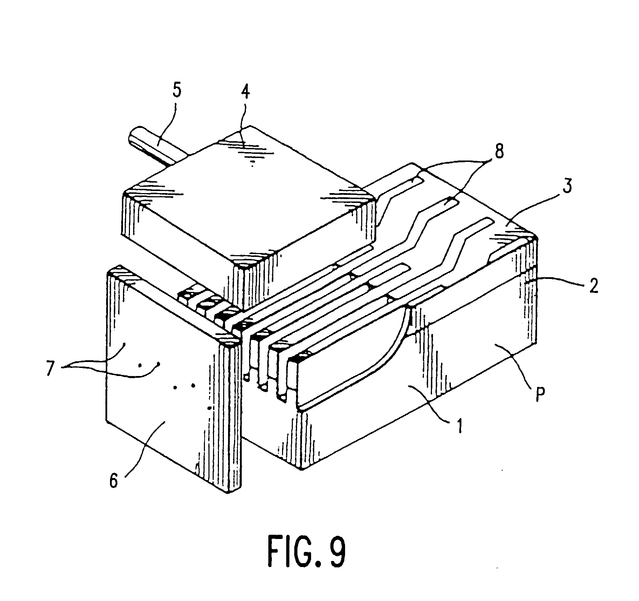

In **Fig.9** ist die prinzipielle Konstruktion einer Vorrichtung (P) zur gepulsten Emission von Flüssigkeitstropfen mit einem piezokeramischen Bauteil nach der Erfindung dargestellt.

Diese Vorrichtung besteht im wesentlichen aus vier Teilen: dem erfindungsgemäßen Bauteil, einem Deckel**(4)** mit Flüssigkeitszufuhr **(5)** und einer Düsenplatte **(6)** mit einer Anzahl von Düsen **(7)**.
Die Stromzuführungen **(8)** zu den Arbeitselektroden **E**_{**n-1**}**, E**_{**n**},**E**_{**n+1**}... werden zweckmäßigerweise im gleichen Arbeitsgang wie die Arbeitelektroden selbst hergestellt. Die Kammern werden durch einen Deckel **(4)** aus Keramik oder Kunststoff verschlossen. Für einen flüssigkeitsdichten Verschluß wird der Deckel entweder nur lose auf den Kammerwänden fixiert, z.B. durch Klammern oder er wird aufgeklebt oder die Kammerwände greifen in Nuten des Deckels ein. Der Deckel enthält weiterhin ein oder mehrere Kanäle, die die Flüssigkeitszufuhr **(5)** mit den Kammern verbindet.

Die Front der Kammern wird durch eine Düsenplatte **(6)** verschlossen, die eine Anordnung von Düsen**(7)** enthält.

Wenn ein elektrisches Signal zwischen je zwei der Stromzuführungen zu den Arbeitselektroden **(8)** angelegt wird, knicken die Kammerwände in die eine oder die andere Richtung ab, dadurch wird das Volumen der dazwischenliegenden Kammern expandiert oder kontrahiert.

Längliche Flüssigkeitsspuren werden bei fortdauernder Tröpfchenemission und Relativbewegung des Werkstückes erzeugt.

## Patentansprüche

1. Piezokeramisches Bauteil mit Kammerstruktur mit mindestens zwei in Gruppen im wesentlichen parallel angeordneten Kammern (ch), wobei innerhalb einer Gruppe alle Kammern eine gemeinsame Kammerbasis (2) und je zwei benachbarte Kammern eine gemeinsame Kammerwand aufweisen und die Innenflächen der Kammerbasis und gegebenenfalls der Kammerwände ganz oder teilweise mit Arbeitselektroden (Eₙ, Eₙ₋₁) belegt sind, und sowohl die Kammerwände als auch die Kammerbasis aus piezoelektrisch polarisiertem Material und gegebenenfalls Hilfselektroden (Eₕ) bestehen,
dadurch gekennzeichnet,
daß die Kammerbasis und das untere Teilstück der Kammerwände antiparallel polarisiert sind.

2. Piezokeramisches Bauteil mit Kammerstruktur nach Anspruch 1,
dadurch gekennzeichnet,
daß das piezoelektrisch polarisierte Material für einen Schermodus polarisiert ist.

3. Piezokeramisches Bauteil mit Kammerstruktur nach Anspruch 1,
dadurch gekennzeichnet,
daß das piezoelektrisch polarisierte Material für einen multiplen Schermodus polarisiert ist.

4. Piezokeramisches Bauteil mit Kammerstruktur nach Anspruch 1,
dadurch gekennzeichnet,
daß das obere Teilstück (3) der Kammerwände parallel zur Kammerbasis polarisiert ist.

5. Piezokeramisches Bauteil mit Kammerstruktur nach Anspruch 1,
dadurch gekennzeichnet,
daß das für einen multiplen Modus polarisierte Material für die Kammerbasis und die Kammerwände aus Schichten mit unterschiedlicher Materialzusammensetzung besteht.

6. Piezokeramisches Bauteil mit Kammerstruktur mit mindestens zwei in Gruppen im wesentlichen parallel angeordneten Kammern (ch), wobei innerhalb einer Gruppe alle Kammern eine gemeinsame Kammerbasis (2) und je zwei benachbarte Kammern eine gemeinsame Kammerwand aufweisen und die Innenflächen der Kammerbasis und gegebenenfalls der Kammerwände ganz oder teilweise mit Arbeitselektroden (Eₙ, Eₙ₋₁) belegt sind, und sowohl die Kammerwände als auch die Kammerbasis aus piezoelektrisch polarisiertem Material und gegebenenfalls Hilfselektroden (Eₕ) bestehen, dadurch gekennzeichnet, daß das piezoelektrisch polarisierte Material bimorph polarisiert ist, so daß in einer jeweils zwei Kammern gemeinsamen Kammerwand das der ersten Kammer benachbarten erste Wandteilstück einschließlich des mit ihm verbundenen Teilstück der Kammerbasis antiparallel zu dem der zweiten Kammer benachbarten Wandteilstücks einschließlich des mit ihm verbundenen Teilstücks der Kammerbasis und antiparallel zum zweiten Wandteilstück der ersten Kammer einschließlich des mit ihm verbundenen Teilstücks der Kammerbasis polarisiert ist.

7. Verfahren zur Herstellung eines piezokeramischen Bauteils mit Kammerstruktur, bei dem an eine vorpolarisierte Platte aus einem Schichtverbund aus einer Basisschicht, einer inneren Hilfselektrode und einer Deckschicht zwei äußere Hilfselektroden angebracht werden, Polarisationsspannungen zwischen den äußeren Hilfselektroden und der inneren Hilfselektrode angebracht werden, so daß die Basisschicht und die Deckschicht antiparallel polarisiert sind, mindestens die obere Hilfselektrode entfernt wird und eine oder mehrere Kammern so angebracht werden, daß sie sich von der Deckschicht durch die Hilfselektrode und durch den oberen Teil der Basisschicht erstrecken, so daß der untere Teil der Basisschicht als Kammerbasis erhalten bleibt, die Innenflächen der Kammer oder Kammern mit Arbeitselektroden belegt werden, eine Polarisationsspannung zwischen der Basiselektrode und den Arbeitselektroden angelegt wird, so daß der untere Teil der Basisschicht antiparallel zum oberen Teil der Basisschicht und parallel zur Deckschicht polarisiert wird.

8. Vorrichtung zur gepulsten Emission von Tropfen mit einem piezokeramischen Bauteil nach Anspruch 1 oder 6.

## Claims

1. A piezoceramic component having a chamber structure and comprising at least two chambers (ch) which are arranged in groups and which are essentially parallel to each other, all chambers of one group having a common chamber base (2) and every two adjacent chambers have a common chamber wall, the inner surfaces of said chamber base and, optionally, of the chamber walls being entirely or partly covered with work electrodes (Eₙ, Eₙ₋₁), and both the chamber walls and the chamber base being composed of a piezoelectrically poled material and, optionally, auxiliary electrodes, characterised in that the chamber base and at least the lower part of the chamber walls are poled antiparallel to each other.

2. A piezoceramic component having a chamber structure as claimed in Claim 1, characterised in that the piezoelectrically poled material is poled for a shear mode.

3. A piezoceramic component having a chamber structure as claimed in Claim 1, characterised in that the piezoelectrically poled material is poled for a multiple shear mode.

4. A piezoceramic component having a chamber structure as claimed in Claim 1, characterised in that the upper part (3) of the chamber walls is poled parallel to the chamber base.

5. A piezoceramic component having a chamber structure as claimed in Claim 1, characterised in that, the material which is poled for a multiple mode and which is used for the chamber base and the chamber walls is composed of layers having a different material composition.

6. A piezoceramic component having a chamber structure comprising at least two chambers (ch) which are arranged in groups and which are essentially parallel to each other, all chambers of one group having a common chamber base (2) and every two adjacent chambers have a common chamber wall, the inner surfaces of said chamber base and, optionally, of the chamber walls being entirely or partly covered with work electrodes (Eₙ, Eₙ₋₁) and both the chamber walls and the chamber base being composed of piezoelectrically polarised material and, optionally, auxiliary electrodes (Eₕ), characterised in that the piezoelectrically polarised material is bimorphously poled, so that in one chamber wall, which is common to two chambers, the first wall portion, including the chamber base portion connected therewith, adjacent to the first chamber is poled antiparallel with respect to the wall portion, including the chamber base portion connected therewith, adjacent to the second chamber, and antiparallel with respect to the second wall portion of the first chamber including the chamber base portion connected therewith.

7. A method of manufacturing a piezoceramic component having a chamber structure, in which a pre-poled sheet composed of a laminate comprising a base layer, an inner auxiliary electrode and a top layer is provided with two outer auxiliary electrodes, poling voltages are applied between the outer auxiliary electrodes and the inner auxiliary electrode, so that the base layer and the top layer are poled antiparallel to each other, at least the upper auxiliary electrode is removed, one or more chambers are arranged so that they extend from the top layer through the auxiliary electrode and the upper part of the base layer, so that the lower part of the base layer remains the chamber base, the inner surfaces of the chamber or chambers are provided with work electrodes, a poling voltage is applied between the base electrode and the work electrodes, so that the lower part of the base layer is poled antiparallel to the upper part of the base layer and parallel to the top layer.

8. A pulsed droplet emission device comprising a piezoceramic component as claimed in Claim 1 or 6.

## Revendications

1. Elément piézoélectrique avec structure à chambres avec au moins deux chambres (ch) disposées de manière essentiellement parallèle en groupes, toutes les chambres au sein d'un groupe comportant une base de chambre commune (2) et respectivement deux chambres voisines une paroi de chambre commune et les surfaces internes de la base de chambre et éventuellement des parois de chambre étant garnies en tout ou en partie d'électrodes de travail (Eₙ, Eₙ₋₁) et tant les parois de la chambre que la base de la chambre se composant d'un matériau polarisé piézoélectriquement et, éventuellement, d'électrodes auxiliaires (E_{H}),
caractérisé en ce
que la base de la chambre et la partie inférieure des parois de la chambre sont polarisées de manière antiparallèle.

2. Elément piézoélectrique avec structure à chambres selon la revendication 1,
caractérisé en ce
que le matériau polarisé piézoélectriquement est polarisé pour un mode de cisaillement.

3. Elément piézoélectrique avec structure à chambres selon la revendication 1,
caractérisé en ce que le matériau polarisé piézoélectriquement est polarisé pour un mode de cisaillement multiple.

4. Elément piézoélectrique avec structure à chambres selon la revendication 1,
caractérisé en ce
que la partie supérieure (3) des parois de la chambre est polarisée parallèlement à la base de la chambre.

5. Elément piézoélectrique avec structure à chambres selon la revendication 1,
caractérisé en ce
que le matériau polarisé pour un mode multiple pour la base de la chambre et les parois de la chambre se compose de couches de composition différente.

6. Elément piézoélectrique avec structure à chambres avec au moins deux chambres (ch) disposées de manière essentiellement parallèle en groupes, toutes les chambres au sein d'un groupe comportant une base de chambre commune (2) et respectivement deux chambres voisines une paroi de chambre commune et les surfaces internes de la base de chambre et éventuellement des parois de chambre étant garnies en tout ou en partie d'électrodes de travail (Eₙ, Eₙ₋₁) et tant les parois de la chambre que la base de la chambre se composant d'un matériau polarisé piézoélectriquement et, éventuellement, d'électrodes auxiliaires (E_{H}),
caractérisé en ce
que le matériau polarisé piézoélectriquement est polarisé de manière bimorphe si bien que, dans une paroi de chambre respectivement commune à deux chambres, la première partie de paroi voisine à la première chambre, y compris la partie reliée à celle-ci de la base de la chambre, est polarisée de manière antiparallèle à la partie de paroi voisine à la deuxième chambre, y compris la partie de la base de chambre reliée à celle-ci et de manière antiparallèle à la deuxième partie de paroi de la première chambre, y compris la partie de la base de chambre reliée à celle-ci.

7. Procédé de fabrication d'un élément piézoélectrique avec structure à chambres, dans lequel deux électrodes auxiliaires externes sont appliquées sur une plaque prépolarisée à partir d'une structure en couches d'une couche de base, d'une électrode auxiliaire interne et d'une couche de recouvrement, des tensions de polarisation entre les électrodes auxiliaires externes et l'électrode auxiliaire interne étant appliquées si bien que la couche de base et la couche de recouvrement sont polarisées de manière antiparallèle, au moins l'électrode auxiliaire supérieure étant éliminée et une ou plusieurs chambres sont appliquées de telle sorte qu'elles s'étendent depuis la couche de recouvrement par l'électrode auxiliaire et par la partie supérieure de la couche de base si bien que la partie inférieure de la couche de base est préservée comme base de chambre, les surfaces internes de la ou des chambres sont garnies d'électrodes de travail, une tension de polarisation est appliquée entre l'électrode de base et les électrodes de travail de telle sorte que la partie inférieure de la couche de base soit polarisée de manière antiparallèle à la partie supérieure de la couche de base et parallèlement à la couche de recouvrement.

8. Dispositif d'émulsion pulsée de gouttes avec un élément piézoélectrique selon l'une des revendications 1 ou 6.
